# EUROPEAN PATENT SPECIFICATION

(11) **EP 1 247 559 B1**
(45) Date of publication and mention of the grant of the patent: **25.05.2005**
(21) Application number: 02006327.7
(22) Date of filing: 21.03.2002
(51) Int. Cl.: B01D 53/04, B01J 35/04, B01D 53/86

(54) **Chemical filter**
Chemischer Filter
Filtre chimique

(30) Priority: 30.03.2001 JP 2001100592
(43) Date of publication of application: 09.10.2002
(73) Proprietor: Nichias Co., Ltd., Tokyo 105-8555 (JP)
(72) Inventor: Tanaka, Minoru, c/o Nichias Co., Ltd., Tokyo 105-8555-0053 (JP); Yamana, Kazuki, c/o Nichias Co., Ltd., Tokyo 105-8555-0053 (JP)
(74) Representative: Müller-Wolff, Thomas, Dipl.-Ing.

(56) References cited:
- EP-A- 1 121 968
- US-A- 5 212 131
- US-A- 5 262 129
- DATABASE WPI Section Ch, Week 199651 Derwent Publications Ltd., London, GB; Class D22, AN 1996-513175 XP002207448 -& JP 08 266866 A (NICHIAS CORP), 15 October 1996 (1996-10-15)

## Description

### BACKGROUND OF THE INVENTION

### Field of the Invention

The present invention relates to a chemical filter used in clean rooms in factories for manufacturing semiconductors and precision electronic devices to remove very low concentration acid gases and organic solvent vapors.

### Description of the Background Art

Because a very slight amount of pollutants such as vapors of organic solvents and acid gases such as SOₓ and NOₓ contained in the atmosphere may cause failures in semiconductor products, these pollutants must be removed to the limit by chemical filters to obtain clean air.

To remove various small amount components from air by using a chemical filter, causing the processing gas to come positively into contact with an impurity removing medium such as activated carbon is very important. Conventional chemical filters with particles of activated carbon and reactants to neutralize acid gases packed in a filter case provide the processing gas with only a small area for contacting the packed particles. Therefore, it has been difficult to increase the efficiency of removing the pollutants. In addition, the large pressure loss in a packed-type chemical filter increases the load for feeding air through the filter, requiring large equipment and high operating costs.

A filter for removing contaminants from a gas is disclosed in US-A-5212131. A filter consists of a support which is made of fibrous material and three reactants deposited on the surface of said support. The reactants are adhered by a sol which forms a webbing after a first and second heat treatment of the support. Under the conditions mentioned in US-A-5212131 a porous coating and a webbing are created with specific properties of the filter material. The deposition is performed by dipping of the support in the sol or by spraying the sol onto the support material. The sol forms a webbing at the fibre-contact points of the support material and the webbing can be controlled by the viscosity of the sol, the blowing of a gas through the matrix of the support material and a first and second heat treatment. The activity of the non-filter material depends on the three reactants deposited on the surface and an increase of the surface area by forming the webbing and the porous coating of certain components of the reactants.

Japanese Patent Application Laid-open No. 26686/1996 discloses a honeycomb structure made from an inorganic fibrous paper on which activated carbon powder, catalysts, and reactants such as alkali and metal salts are adsorbed. The honeycomb structure can suppress pressure loss and ensures reasonable gas-solid contact.

However, the honeycomb structure disclosed in Japanese Patent Application Laid-open No. 26686/1996 cannot sufficiently remove polar substances such as acid gases which are difficult to be adsorbed in activated carbon, although the device can comparatively easily remove non-polar substances such as vapors of organic solvents which are adsorbed in non-polar activated carbon. Because of this, ionic pollutants such as SOx and NOx must be separately removed by an ion-exchange resin secured in a substrate with an adhesive by using, for example, an apparatus disclosed in Japanese Patent Application Laid-open No. 262833/2000. Specifically, because there has been no single chemical filter which can efficiently remove both organic solvent vapors and acid gases, it has been necessary to use a chemical filter for non-polar substances which can adsorb organic solvent vapors and another chemical filter for polar substances which can adsorb acid gases. The equipment had disadvantages in terms of both installation and cost.

An object of the present invention is therefore to provide a single chemical filter which can remove both organic solvent vapors and acid gases.

In view of the above-described situation, the inventor of the present invention has conducted extensive studies and, as a result, has found that a filter with an oxidation catalyst having an oxidizing power sufficient to oxidize acid gases, a reactant such as an inorganic base to neutralize acid gases, and activated carbon carried thereon can increase the rate of removal of acid gases. Specifically, such a filter can increase the acidity of nitrogen oxides by the oxidizing action of the acidic catalyst, thereby causing the nitrogen oxides to be easily reacted with the reactant such as an inorganic base and to be easily adsorbed in activated carbon. This finding has led to the completion of the present invention.

### SUMMARY OF THE INVENTION

Specifically, the present invention provides a chemical filter comprising a carrier with a honeycomb structure made from a fibrous paper having a fiber void of 70-95%, an oxidation catalyst, an acid gas reactant, and activated carbon powder carried on the carrier.

Other objects, features and advantages of the invention will hereinafter become more readily apparent from the following description.

### BRIEF DESCRIPTION OF THE DRAWINGS

Figure 1 is a perspective view schematically showing a honeycomb structure prepared in Example 1.

Figure 2 is a graph showing the relationship between the air feed time and the nitrogen dioxide removal rate.

Figure 3 is a graph showing the relationship between the air feed time and the DBP removal rate.

Figure 4 is a graph showing the relationship between the air feed rate and the pressure loss.

### DETAILED DESCRIPTION OF THE INVENTION AND PREFERRED EMBODIMENTS

The chemical filter of the present invention comprises a carrier with a honeycomb structure made from a fibrous paper, and an oxidation catalyst, an acid gas reactant, and activated carbon powder carried on the carrier. The fibrous paper forming the honeycomb carrier is a nonwoven fabric. Inorganic fibers such as ceramic fiber, alumina fiber, silica alumina fiber, and rock wool can be given as the fiber materials. Of these, ceramic fiber is preferable due to the superior corrugating processability. Ceramic fiber generally indicates silica alumina fiber containing 40-60 wt% of silica and 40-60 wt% of alumina. Glass fiber is not preferable because glass fiber reacts with hydrofluoric acid generated in the semiconductor fabrication process and produces a boron compound which pollutes clean rooms.

The average fiber diameter of fibrous paper is usually 2-20 ìm, preferably 3-16 ìm, and more preferably 3-9 ìm. The average fiber diameter in the above range is preferable because a large amount of oxidation catalyst, acid gas reactant, activated carbon powder, and the like can be easily retained in fine voids of the fiber.

The void ratio of the fibrous paper is 70-95%, and preferably 80-90%. The void ratio in the above range is preferable because a large amount of oxidation catalyst, acid gas reactant, activated carbon powder, and the like can be easily retained in the voids. A void ratio exceeding 95% is not preferable because such a larger void ratio decreases the strength of the fibrous paper.

A thickness of the fibrous paper is usually 0.1-0.6 mm, and preferably 0.2-0.3 mm. The thickness in this range provides the fibrous paper with well-balanced strength, contact efficiency, and pressure loss. If the thickness is less than 0.1 mm, the strength is small; if more than 0.6 mm, the contact area per unit volume of the honeycomb carrier is small.

There are no specific limitations to the type of the honeycomb carrier inasmuch as such a carrier is made of fibrous paper and has a honeycomb structure. One example is a plate made from flat fibrous paper boards and corrugated fibrous paper boards alternately laminated, with the flat boards attached along the hills of the corrugated fibrous paper boards with an adhesive. This type of honeycomb carrier can be fabricated from corrugated boards made by corrugating flat fibrous paper boards by a corrugating machine and alternately attaching the corrugated board and flat board.

The wave pitch, or the intervals of waves (wavelength), in the corrugated fibrous paper board composing the honeycomb carrier is usually 2.0-5.0 mm, and preferably 2.5-3.5 mm. The height of hills, or the width of waves, in the corrugated fibrous paper board composing the honeycomb carrier is usually 1.0-7.0 mm, and preferably 1.0-3.0 mm. The pitches and hills in the above range ensure well-balanced removal performance and ratio of openings.

A catalyst which can oxidize NOₓ, SOₓ, and the like in the processing gas is used as an oxidation catalyst to be carried on the carrier with a honeycomb structure. Specific examples include manganese dioxide, vanadium pentoxide, copper oxide, and nickel oxide. Among these, manganese dioxide is particularly preferable due to the strong oxidation power, ease of handling, and the properties not requiring oxidation treatment by burning or the like after being carried on the honeycomb carrier. The amount of the oxidation catalyst to be carried on the carrier per unit volume of the chemical filter is usually 5-80 kg/m³, and preferably 15-70 kg/m³. The amount of the oxidation catalyst to be carried on the carrier in this range increases the removal performance. In the present invention, the processing gas is first caused to come into contact with the oxidation catalyst, whereby the gas components are oxidized and the oxidation number of NOₓ and SOₓ in the processing gas increases. The increase in the oxidation number of NOₓ and SOₓ results in production of nitric acid rather than nitrous acid and sulfuric acid rather than sulfurous acid when the processing gas comes into contact with water. This, in turn, increases the acidity of the processing gas and renders the processing gas more reactive when coming into contact with an acid gas reactant.

An acid gas reactant with high reactivity with the acid gases in the processing gas by a neutralization reaction, for example, is used as an acid gas reactant to be carried on the honeycomb carrier. Specific examples are calcium hydroxide, calcium carbonate, and the like. Of these, calcium hydroxide is preferable because the calcium hydroxide is inexpensive and easy to handle. The amount of the acid gas reactant to be carried on the carrier per unit volume of the chemical filter is usually 10-100 kg/m³, and preferably 40-70 kg/m³. The amount of the acid gas reactant carried on the carrier in this range increases the removal performance.

Activated carbon powder to be carried on the honeycomb carrier has an average particle diameter usually of 3-40 µm, and preferably 5-20 µm. The average particle diameter of activated carbon powder in the above range is preferable to ensure easy application of the activated carbon to fibers in the fibrous paper and easy handling of the resulting fibrous paper. The BET specific surface area of the activated carbon powder is usually 100-1,000 m²/g, and preferably 200-500 m²/g. The BET specific surface area of activated carbon powder in the above range is preferable to ensure easy handling of the fibrous paper, because the activated carbon powder with a BET specific surface area in this range can be applied to fibers in the fibrous paper before fabricating a honeycomb carrier. The amount of activated carbon powder carried on the carrier per unit volume of the fibrous paper forming the chemical filter is usually 50-150 g/m³, and preferably 80-100 g/m³. The amount of activated carbon powder carried on the carrier in this range increases the removal performance and ensures superior processability.

As the manner of carrying the oxidation catalyst, acid gas reactant, and activated carbon powder on the chemical filter of the present invention, either a single stage structure of uniformly distributing these components all through the honeycomb carrier in the air feed direction or a two-stage structure of placing the oxidation catalyst in the upstream side of air feeding in the honeycomb carrier and placing the acid gas reactant and activated carbon powder in the downstream side can be employed. The advantage of the single stage structure is its easy fabrication, whereas the advantage of the two-stage structure is the high efficiency of removal of acid gas and organic solvent vapor due to adsorption of the acid gas by the acid gas reactant and activated carbon powder after the increase in the oxidation number. The chemical filter with a two-stage structure may be an integral body consisting of an upstream section and a downstream section attached to the upstream section, or may consist of an upstream section placed in the front end of the processing gas flow and a downstream section separately disposed next to the upstream section, the two sections acting substantially as one body. The latter type chemical filter may have the upstream section and downstream section either attached to each other or separately placed.

As the method of causing the oxidation catalyst, acid gas reactant, and activated carbon powder to be carried on the honeycomb carrier, a method of preparing slurry from these components and a binder, dipping the honeycomb carrier in the slurry, and drying the carrier can be given, for example. As the binder, silica sol, alumina sol, and the like can be given. Because activated carbon powder requires a long time to disperse in slurry due to the powdery properties, it is desirable to cause the activated carbon powder to be previously incorporated in the fibrous paper. When causing an aqueous compound such as sodium hydroxide solely to be carried on the honeycomb carrier as an acid gas reactant, such a compound may be carried without using a binder or the like by simply dipping the carrier in the aqueous solution and drying.

The chemical filter of the present invention is useful, for example, as a filter used in clean rooms in factories for manufacturing semiconductors and precision electronic devices to remove very low concentration acid gases and organic solvent vapors.

### EXAMPLES

The present invention will be described in more detail by examples, which should not be construed as limiting the present invention.

### Example 1

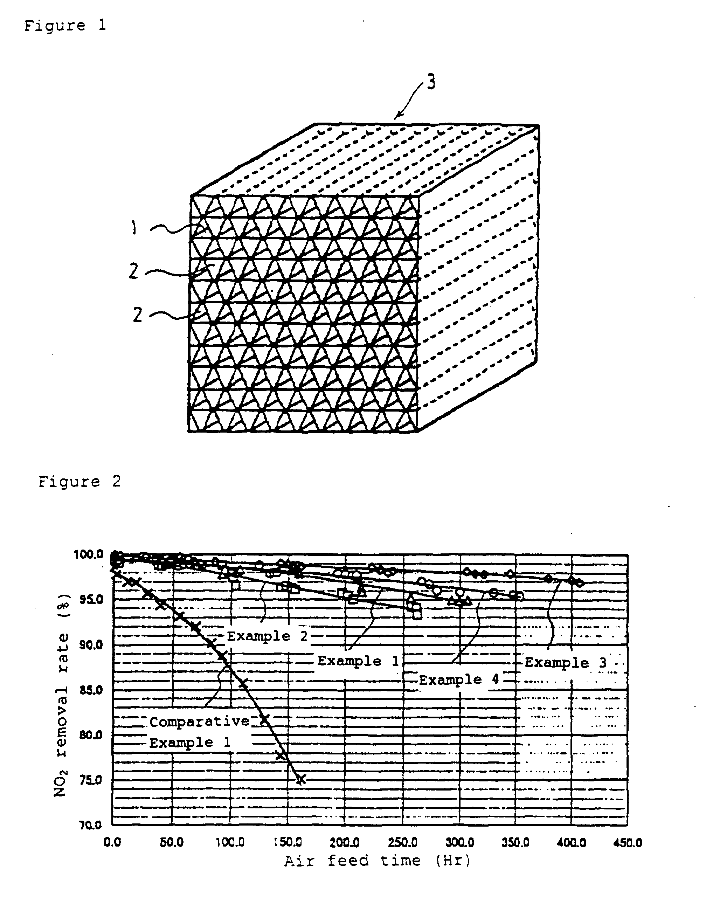

A honeycomb structure 3 shown in Figure 1 was prepared by alternately laminating and causing to adhere a flat substrate paper 1 made of silica alumina fiber with a void of 85% and a corrugated substrate paper 2 with sine waves formed by corrugating the flat substrate paper 1. To ensure well-balanced gas-catalyst contact efficiency and pressure loss, the flat paper with a thickness of 0.2 mm was used. The corrugated paper had a thickness of 0.2 mm, a wave pitch of 3.3 mm, and a wave height of 1.9 mm. The honeycomb structure thus obtained was dipped in a slurry containing manganese dioxide and silica sol and dried to obtain a honeycomb structure with 70 kg/m³ manganese dioxide carried thereon and a residual void of 70%. The honeycomb structure was cut to obtain an upstream filter with a thickness of 20 mm in the air feed direction.

Another honeycomb structure was prepared in the same manner as the upstream filter except that instead of the flat substrate paper and the corrugated substrate paper used for the honeycomb structure for the upstream filter, a flat substrate paper with 60 g/m² of activated carbon powder (average particle diameter: 5 µm, BET specific area: 500 m²/g) incorporated therein and a corrugated substrate paper with sine waves formed by corrugating the latter flat substrate paper were used. The resulting honeycomb structure was dipped in an aqueous solution of calcium hydroxide and dried to obtain a honeycomb structure with 40 kg/m³ calcium hydroxide carried thereon. The honeycomb structure was cut to obtain a downstream filter with a thickness of 40 mm in the air feed direction.

The upstream and downstream filters were attached to obtain a chemical filter consisting of an upstream section and downstream section.

This chemical filter was tested for the change of the removal rate of nitrogen dioxide and n-dibutyl phthalate (DBP) over time and the pressure loss in different gas feed rates. The results are shown in Table 1 and Figures 2-4. In Table 1, only the period of time required for the chemical filter to lose 95% of NO₂ and DBP removing capability is indicated.

### <Method of measuring nitrogen dioxide removal rate>

NO₂ concentration in the gas before treating: 200 ppb
Gas feed rate: 0.5 m/sec

The gas was caused to continuously pass through the chemical filter under the above conditions to determine the change on the NO₂ concentration in the gas after passing through the chemical filter over time.

### <Method of measuring DBP removal rate>

DBP concentration in the gas before treating: 30 ppb
Gas feed rate: 0.5 m/sec

The gas was caused continuously to pass through the chemical filter under the above conditions to determine the change in the DBP concentration in the gas after passing through the chemical filter over time.

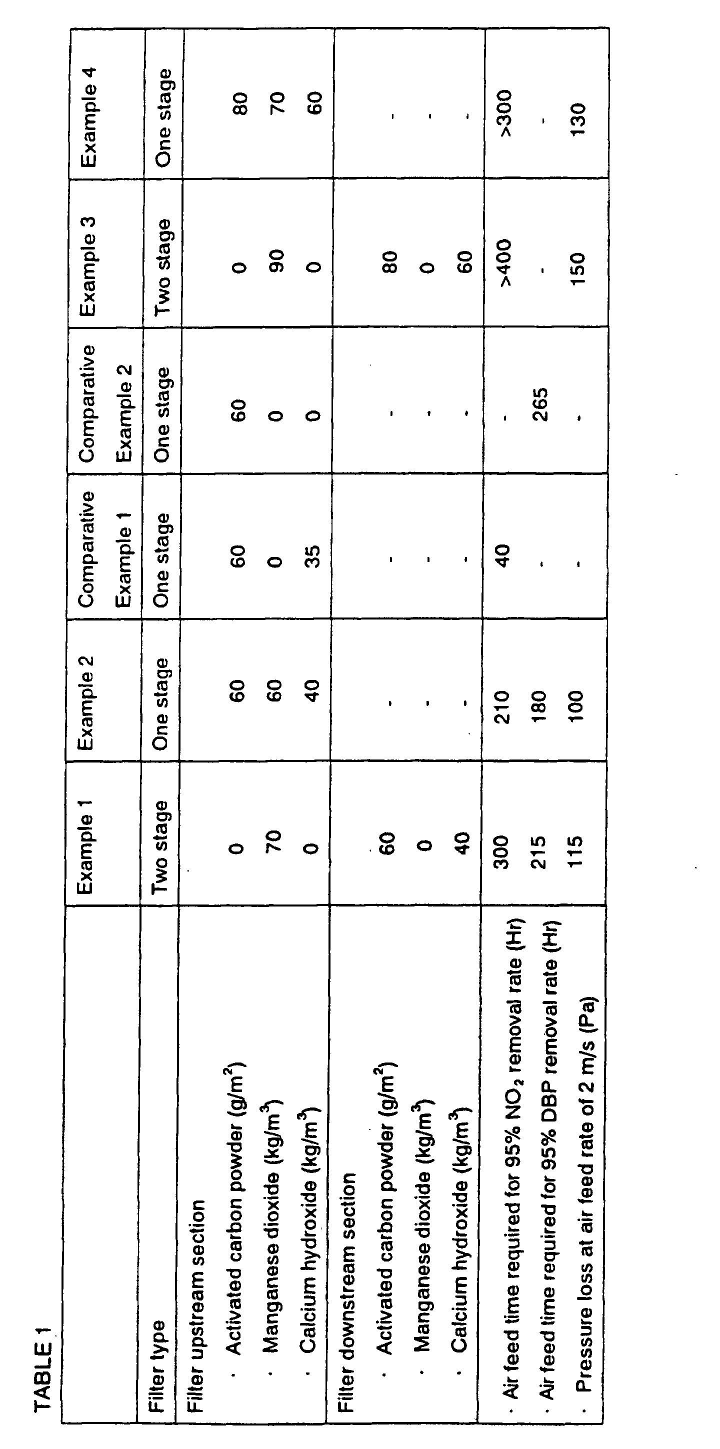

### Example 2

The same honeycomb structure as the honeycomb structure for the downstream filter in Example 1 was prepared. The honeycomb structure was dipped in a slurry containing manganese dioxide, calcium hydroxide, and silica sol and dried to obtain a honeycomb structure with 60 g/m³ of activated carbon powder, 60 kg/m³ manganese dioxide, and 40 kg/m³ of calcium hydroxide carried thereon. The honeycomb structure was cut to obtain a chemical filter with a thickness of 40 mm in the air feeding direction.

The chemical filter was tested for the change of the removal rate of nitrogen dioxide and DBP over time and the pressure loss in different gas feed rates in the same manner as in Example 1. The results are shown in Table 1 and Figures 2-4.

### Comparative Example 1

The same honeycomb structure as the honeycomb structure for the downstream filter in Example 1 was prepared. The resulting honeycomb structure was dipped in an aqueous solution of calcium hydroxide and dried to obtain a honeycomb structure with 60 g/m³ of activated carbon powder and 35 kg/m³ calcium hydroxide carried thereon. The honeycomb structure was cut to obtain a chemical filter with a thickness of 40 mm in the air feeding direction.

The change of the removal rate of nitrogen dioxide through the chemical filter over time was determined in the same manner as in Example 1. The results are shown in Table 1 and Figure 2.

### Comparative Example 2

The honeycomb structure was cut in the same manner as the honeycomb structure for preparing the downstream filter in Example 1 to obtain a chemical filter with a thickness of 40 mm in the air feed direction. This chemical filter employs the same honeycomb structure as that used for preparing the downstream filter in Example 1, but differs from the downstream filter of Example 1 in that no calcium hydroxide was carried on this chemical filter.

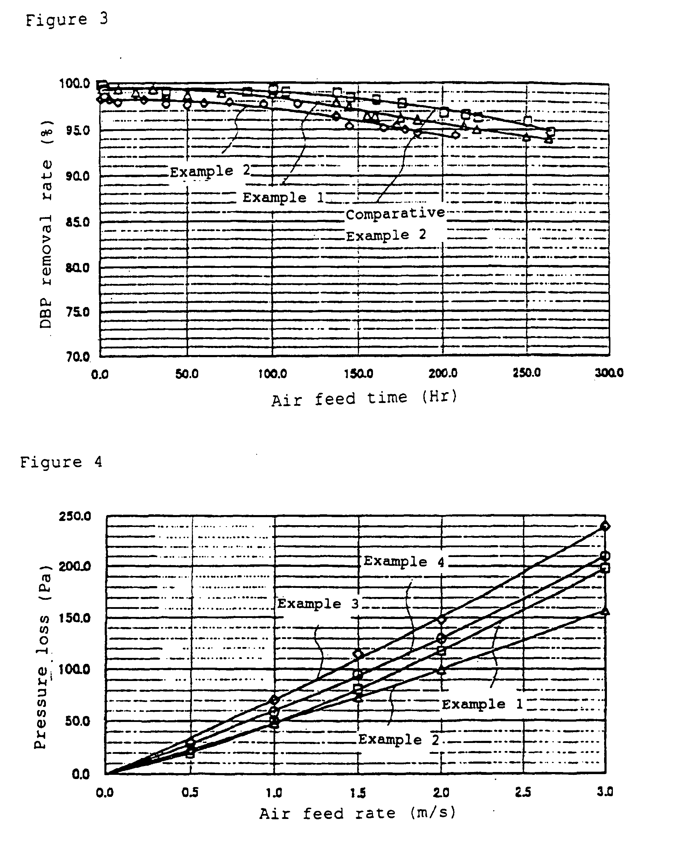

The change of the removal rate of DBP through the chemical filter over time was determined in the same manner as in Example 1. The results are shown in Table 1 and Figure 3.

### Example 3

A honeycomb structure was prepared in the same manner as the upstream filter of the Example 1, except for using a flat substrate paper of silica alumina fiber (average fiber diameter: 9 µm, void ratio: 85%, thickness: 0.2 mm) and a corrugated substrate paper with sine waves (thickness: 0.2 mm, pitch: 3.3 mm, wave height: 1.9 mm) formed by corrugating the flat substrate paper. The honeycomb structure was dipped in a slurry containing manganese dioxide and silica sol and dried in the same manner as the upstream filter in Example 1 to obtain a honeycomb structure with 90 kg/m³ manganese dioxide carried thereon. The honeycomb structure was cut to obtain a upstream section filter with a thickness of 20 mm in the air feed direction.

Another honeycomb structure was prepared in the same manner as the upstream section filter except that instead of the flat substrate paper and the corrugated substrate paper used for the honeycomb structure for the upstream section filter, a flat substrate paper with 80 g/m² of activated carbon powder (average particle diameter: 5 µm, BET specific area: 500 m²/g) incorporated therein and a corrugated substrate paper with sine waves formed by corrugating this flat substrate paper were used. The resulting honeycomb structure was dipped in an aqueous solution of calcium hydroxide and dried to obtain a honeycomb structure with 60 kg/m³ calcium hydroxide carried thereon. The honeycomb structure was cut to obtain a downstream filter with a thickness of 40 mm in the air feeding direction.

The upstream and downstream filters were attached to obtain a chemical filter consisting of an upstream section and downstream section.

The change of the removal rate of nitrogen dioxide through the chemical filter over time and the pressure loss for different gas feed rates were determined in the same manner as in Example 1. The results are shown in Table 1 and Figures 2 and 4.

### Example 4

The same honeycomb structure as the honeycomb structure for the downstream filter in Example 3 was prepared. The honeycomb structure was dipped in a slurry containing manganese dioxide, calcium hydroxide, and silica sol and dried to obtain a honeycomb structure with 80 g/m³ of activated carbon powder, 70 kg/m³ manganese dioxide, and 60 kg/m³ of calcium hydroxide carried thereon. The honeycomb structure was cut to obtain a chemical filter with a thickness of 40 mm in the air feeding direction.

The change of the removal rate of nitrogen dioxide through the chemical filter over time and the pressure loss for different gas feed rates were determined in the same manner as in Example 1. The results are shown in Table 1 and Figures 2 and 4.

The above results indicate that the period of time required for the chemical filter to lose 95% of the NO₂ removing capability is significantly longer in Examples 1 and 2 than in Comparative Example 1. The reason why this gas feed period of time is longer in Example 1 than in Example 2 is thought to be due to the larger amount of manganese dioxide carried on the two-stage chemical filter in Example 1 than in the chemical filter of Example 2. The increased amount of manganese dioxide increases the contact efficiency of manganese dioxide and nitrogen dioxide and oxidizes NO₂ into NO₃ which is more reactive with alkali. NO₃ thus efficiently neutralize calcium hydroxide using water in the air as a reaction medium. The chemical filters of Examples 3 and 4 exhibited a pressure loss slightly larger than the chemical filters of Examples 1 and 2, but their NO₂ removing rate was improved. The same reason as in the Examples 1 and 2 can be applied to the longer gas feed time for the chemical filter of Example 3 than for the chemical filter of Example 4.

Because the processing gas is caused to come into contact with manganese dioxide simultaneously with or before the gas is caused to come contact with activated carbon powder and acid gas reactant using the chemical filter of the present invention, the reactivity of the gas is increased by the increased oxidation number of acid gases due to the manganese dioxide before the gas reacts with the acid gas reactant. This renders the acid gas in the processing gas more readily adsorbed by the acid gas reactant, thereby increasing the removal rate of the acid gas. The removal rate of organic solvent vapors in the processing gas can also be increased by the use of activated carbon powder. In addition, the honeycomb structure employed in the chemical filter of the present invention not only reduces the pressure loss through the chemical filter, but also can decrease the size of the processing unit and save energy.

Obviously, numerous modifications and variations of the present invention are possible in light of the above teachings. It is therefore to be understood that, within the scope of the appended claims, the invention may be practiced otherwise than as specifically described herein.

## Claims

1. A chemical filter comprising a carrier with a honeycomb structure made from a fibrous paper having a fiber void of 70-95 %, an oxidation catalyst, an acid gas reactant, and activated carbon powder carried on the carrier, wherein as an oxidation catalyst manganese dioxide, vanadium pentoxide, copper oxide or nickel oxide are carried on the honeycomb carrier.

2. The chemical filter according to claim 1, wherein the oxidation catalyst, the acid gas reactant, and the activated carbon powder are uniformly carried on the carrier with a honeycomb structure.

3. The chemical filter according to claim 1, wherein the oxidation catalyst is carried on an upstream section of the air feed in the carrier with a honeycomb structure and the acid gas reactant and activated carbon powder are carried on a downstream section in the carrier with a honeycomb structure.

4. The chemical filter according to claim 1, wherein the fibrous paper is inorganic fibrous paper.

5. The chemical filter according to claim 4, wherein the inorganic fibrous paper has an average fiver diameter of 2-20 µm.

6. A chemical filter according to claim 1 wherein the activated carbon powder has been incorporated into the fibrous paper.

7. A chemical filter according to claim 6 wherein the honeycomb carrier carries in addition to the previously incorporated carbon powder an acid gas reactant.

8. A chemical filter according to claim 7 wherein the acid gas reactant with high reactivity for a neutralization reaction is calcium hydroxide.

9. A chemical filter according to claim 9 wherein the amount of the oxidation catalyst to be carried on the carrier per unit volume of the chemical filter is 5 to 80 kg/m³.

## Patentansprüche

1. Ein chemisches Filter, bestehend aus einem Trägermaterial mit wabenförmiger Struktur, welches aus faserhaltigem Papier hergestellt ist und einen faserfreien Anteil von 70 bis 95 % aufweist, ferner bestehend aus einem Oxydationskatalysator, einem säurehaltigen, gasförmigen Reaktionsmittel und pulvensrerter Aktivkohle, die auf dem Trägermaterial aufgebracht ist, wobei Mangansuperoxyd, Vanadin-Pentoxyd, Kupferoxyd oder Nickeloxyd auf dem wabenförmigen Trägermaterial als Oxydationskatalysator verwendet wird.

2. Das chemische Filter gemäß Patentanspruch 1, wobei der Oxydationskatalysator, sowie das säurehaltige, gasförmige Reaktionsmittel und die pulverisierte Aktivkohle auf dem Trägermaterial mit wabenförmiger Struktur gleichmäßig aufgetragen sind.

3. Das chemische Filter gemäß Patentanspruch 1, wobei der Oxydationskatalysator in einem vorderen Abschnitt vor dem Lufteinlass auf dem Trägermaterial mit wabenförmiger Struktur angeordnet ist und das säurehaltige, gasförmige Reaktionsmittel und die pulverisierte Aktivkohle in einem dahintertiagenden Abschnitt des Trägermaterials mit wabenförmiger Struktur angeordnet sind.

4. Das chemische Filter gemäß Patentanspruch 1, wobei das faserhaltige Papier aus anorganischer Faser besteht.

5. Das chemische Filter gemäß Patentanspruch 1, wobei das anorganische, faserhaltige Papier einen durchschnittlichen Faserdurchmesser von 2-20 µm aufweist.

6. Ein chemisches Filter gemäß Patentanspruch 1, wobei die pulverisierte Aktivkohle in das faserhaltige Papier integriert ist.

7. Ein chemisches Filter gemäß Patentanspruch 6, wobei das wabenförmige Trägermaterial, zusätzlich zur vorher integrierten, pulverisierten Aktivkohle auch ein säurehaltiges, gasförmiges Reaktionsmittel mitführt.

8. Ein chemisches Filter gemäß Patentanspruch 7, wobei das säurehattige, gasförmige Reaktionsmittel Calciumhydroxid ist, das eine hohe Reaktionsfähigkeit zur Neutralisierung hat,.

9. Ein chemisches Filter gemäß Patentanspruch 1, wobei die Menge des Oxydationskatalysators, der auf dem Trägermaterial angeordnet ist, pro Volumeneinheit des chemischen Filters 5 bis 80 kg/m³ beträgt.

## Revendications

1. Un filtre chimique comprenant un matériau support à structure en alvéoles, fabriqué avec un papier de fibres, dont une partie de 70 - 95 % est exempte de fibres, composé en outre d'un convertisseur catalytique d'oxydation, d'un agent actif de gaz acide et d'une poudre de charbon actif qui est appliquée sur le matériau support, compte tenu que le convertisseur catalytique d'oxydation peut être, soit le dioxyde de manganèse, soit le pentoxyde de vanadium, ou encore l'oxyde de cuivre ou de nickel, appliqué sur le matériau support en alvéoles.

2. Le filtre chimique conformément à la spécification 1, compte tenu que le convertisseur catalytique d'oxydation, ainsi que l'agent actif de gaz acide et la poudre de charbon actif sont appliqués uniformément sur le matériau support à structure en alvéoles.

3. Le filtre chimique conformément à la spécification 1, compte tenu que le convertisseur catalytique d'oxydation est installé sur le secteur en amont de l'accès d'air sur le matériau support à structure en alvéoles et que l'agent actif de gaz acide et la poudre de charbon actif sont appliqués sur un secteur en aval dans le matériau support à structure en alvéoles.

4. Le filtre chimique conformément à la spécification 1, dont le papier de fibres est composé de fibres inorganiques.

5. Le filtre chimique conformément à la spécification 1, dont le diamètre de fibre du papier en fibres inorganiques est de 2 - 20 µm en moyenne.

6. Le filtre chimique conformément à la spécification 1, dont la poudre de charbon actif est intégrée dans le papier de fibres.

7. Le filtre chimique conformément à la spécification 6, dont le matériau support à structure en alvéoles, en plus de la poudre de charbon actif intégrée, contient également un agent actif de gaz acide.

8. Le filtre chimique conformément à la spécification 7, dont l'agent actif de gaz acide ayant une haute capacité de réaction, est l'hydroxyde de calcium pour la réaction neutralisante.

9. Le filtre chimique conformément à la spécification 1, dont la quantité de convertisseur catalytique d'oxydation devant être appliquée sur le matériau support, comprend de 5 à 80 kg/m³ par unité de volume du filtre chimique.
